(19) **Europäisches Patentamt European Patent Office Office européen des brevets**

(11) **EP 4 716 127 A1**

(12) **EUROPEAN PATENT APPLICATION**
published in accordance with Art. 153(4) EPC

(43) Date of publication:
**25.03.2026 Bulletin 2026/13**

(21) Application number: **25803055.0**

(22) Date of filing: **15.05.2025**

(51) International Patent Classification (IPC):
*H04L 1/00* (2006.01)

(52) Cooperative Patent Classification (CPC):
**H03M 13/29; H03M 13/39; H04B 1/7163; H04B 1/7176; H04L 1/00**

(86) International application number:
**PCT/CN2025/095159**

(87) International publication number:
**WO 2025/237379 (20.11.2025 Gazette 2025/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.05.2024 CN 202410622969**

(71) Applicant: **Calterah Semiconductor Technology (Shanghai) Co., Ltd.**
**Shanghai 201210 (CN)**

(72) Inventors:
• **BAI, Qing**
**Shanghai 201210 (CN)**
• **HAN, Zeyu**
**Shanghai 201210 (CN)**

(74) Representative: **Murgitroyd & Company**
**165-169 Scotland Street**
**Glasgow G5 8PL (GB)**

(54) **JOINT DE-MAPPING AND DECODING METHOD AND APPARATUS, DECODER, INTEGRATED CIRCUIT, DEVICE, AND EQUIPMENT**

(57) A joint de-mapping and decoding method and apparatus, a decoder, an integrated circuit, a device, and equipment, applied to the technical field of digital signal processing. A received symbol comprising a plurality of components is first acquired, wherein each component of the received symbol is jointly determined by a plurality of encoded bits involved in symbol mapping; when state transition is performed during a decoding process, a likelihood value of each symbol value is computed on the basis of the value of the received symbol, and branch metrics of each state transition branch is obtained on the basis of the likelihood values.

FIG. 1A

FIG. 1B

## EP 4 716 127 A1

### Description

The present application claims the priority to a Chinese patent application No. 202410622969.6 filed on May 17, 2024, entitled "Joint Inverse Mapping and Decoding Method and Apparatus, Integrated Circuit, Electromagnetic wave device, and User Terminal Equipment", contents of which should be understood to be incorporated into the present application by reference.

Technical Field

The present disclosure relates to, but is not limited to, the field of signal processing technologies, and more particularly to a joint demapping and decoding method and apparatus, a decoder, an integrated circuit, a device and equipment.

Background

An Ultra Wide Band (UWB) is a wireless communication technology whose physical layer (PHY) defines ways of sending and receiving signals. The UWB technology can provide a higher data transmission rate and a more accurate positioning capability by using an extremely wide spectrum (usually between 3.1 GHz and 10.6 GHz) and a short pulse (a time domain width is at a nanosecond level) to transmit data, but its decoding performance needs to be improved.

Summary

The following is a summary of subject matters described herein in detail. This summary is not intended to limit the scope of protection of claims.

An embodiment of the present disclosure provides a joint demapping and decoding method, including:

acquiring a received symbol including a plurality of components, wherein each component of the received symbol is jointly determined by a plurality of coded bits participating in symbol mapping;

calculating a likelihood value of each value of the symbol according to a value of the received symbol when state transition is performed in a decoding process, and obtaining a branch metric of each state transition branch based on the likelihood value.

An embodiment of the present disclosure also provides a joint demapping and decoding method, including: acquiring a non-Gray modulation constellation diagram; and performing decoding based on correlation between mapped symbols.

An embodiment of the present disclosure also provides a joint demapping and decoding method, including: acquiring a non-Gray modulation constellation diagram; and performing decoding using a maximum logarithmic approximation mode.

An embodiment of the present disclosure also provides a joint demapping and decoding apparatus, including a memory and a processor, wherein the memory stores a computer program, wherein the joint demapping and decoding method according to any embodiment of the present disclosure can be implemented when the processor executes the computer program.

An embodiment of the present disclosure also provides a decoder including a branch metric generation module and a path processing module, wherein

the branch metric generation module is configured to acquire a received symbol including a plurality of components from an input end, obtain a branch metric of each state transition branch according to the joint demapping and decoding method according to any embodiment of the present disclosure, and output the branch metric of each state transition branch to the path processing module;

the path processing module is configured to update and record a path metric of each state based on the branch metric, obtain a path with a largest path metric by backtracking when an end point of a path is reached, and obtain a decoded encoded bit sequence based on a state transition branch of the path with the largest path metric.

An embodiment of the present disclosure also provides an integrated circuit including a radio frequency module, an analog signal processing module, and a digital signal processing module connected in sequence; wherein the radio frequency module is configured to generate and transmit an electromagnetic wave signal and receive an electromagnetic wave signal; the analog signal processing module is configured to perform down-frequency processing on the received electromagnetic wave signal to obtain an intermediate frequency signal; the digital signal processing module is configured to perform analog-to-digital conversion on the intermediate frequency signal to obtain a digital signal and process the data signal; wherein the digital signal processing module includes the decoder according to any embodiment of the present disclosure.

An embodiment of the present disclosure also provides an electromagnetic wave device, including: a carrier; the integrated circuit according to any embodiment of the present disclosure which is disposed on the carrier; and an antenna disposed on the carrier, and integrated with the integrated circuit as an integral device or separately disposed; wherein the integrated circuit is connected with the antenna for transmitting the electromagnetic wave signal and/or receiving the electromagnetic wave signal.

An embodiment of the present disclosure also provides the terminal equipment, which includes the equipment body; and the electromagnetic wave device according to any embodiment of the present disclosure disposed on the equipment body; wherein the electromagnetic wave device is used for target detection and/or communication to provide reference information for operation of the equipment body.

An embodiment of the present disclosure also provides a non-transitory computer readable storage medium having a computer program stored thereon, and when the computer program is executed by a processor, the joint demapping and decoding method according to any embodiment of the present disclosure can be implemented.

After drawings and detailed description are read and understood, other aspects may be understood.

Brief Description of Drawings

Accompanying drawings are used for providing understanding of technical solutions of the present disclosure, and form a part of the specification. They are used for explaining the technical solutions of the present disclosure together with embodiments of the present disclosure, but do not form a limitation on the technical solutions of the present disclosure. Shapes and sizes of various components in the drawings do not reflect actual scales, but are only intended to schematically illustrate contents of the present disclosure.

FIG. 1A is a schematic diagram of encoding and symbol mapping in a UWB physical layer according to an embodiment, and FIG. 1B is a schematic diagram of symbol demapping and decoding in this embodiment.

FIG. 2 is a schematic diagram of symbol mapping and constellation diagram in different modes of a UWB physical layer according to an embodiment.

FIG. 3 is a schematic diagram of a structure of an apparatus for calculating a log likelihood ratio of a symbol and decoding according to an embodiment.

FIG. 4 is a flowchart of a joint demapping and decoding method according to an embodiment of the present disclosure.

FIG. 5 is a schematic diagram of a structure of a decoder according to an embodiment of the present disclosure.

FIG. 6 is a comparison diagram between error correction performance of joint demapping and decoding using a method of an embodiment of the present disclosure and error correction performance of demapping and decoding using another method.

FIG. 7A is a block diagram of a decoder according to an embodiment of the present disclosure.

FIG. 7B is a schematic diagram of an integrated circuit according to an embodiment of the present disclosure.

FIG. 8 is a schematic diagram of terminal equipment according to an embodiment of the present disclosure.

FIG. 9 is a schematic diagram of a joint demapping and decoding apparatus according to an embodiment of the present disclosure.

FIG. 10a is a diagram of performing Binary (burst) Position Modulation (BPM) - Binary Phase Shift Keying (BPSK) joint modulation on non-Gray code.

FIG. 10b is a diagram of performing BPSK / Quadrature Phase Shift Keying (QPSK) modulation on Gray code.

FIG. 11 is a schematic diagram of state transition during Viterbi decoding.

FIG. 12 is a non-Gray code diagram of a High Rate Pulse (HRP) - Enhanced Relative Error Detection and Verification (ERDEV) mode.

FIG. 13 is a comparison diagram of implementation performance of solutions.

FIG. 14 is a flowchart of a joint demapping and decoding method according to another embodiment of the present disclosure.

FIG. 15 is a flowchart of a joint demapping and decoding method according to yet another embodiment of the present disclosure.

Detailed Description

A plurality of embodiments are described for the present disclosure, but the description is exemplary rather than restrictive. It will be apparent to those of ordinary skills in the art that there may be more embodiments and implementation solutions within the scope contained in the embodiments described in the present disclosure.

In the description of the present disclosure, words such as "exemplary" or "for example" are used to indicate an example, illustration, or explanation. Any embodiment described as "exemplary" or "for example" in the present application should not be construed as superior or more advantageous than other embodiments. Herein, "and/or" is a description of an association relationship between association objects, and means that there may be three kinds of relationships, for example, A and/or B, which may mean that A alone exists, A and B simultaneously exist, and B alone exists. "Plurality" means two or more than two. In addition, in order to clearly describe technical solutions of the embodiments of the present disclosure, words such as "first" and "second" are used to distinguish same items or similar items having basically same actions and functions. Those of ordinary skills in the art may understand that the words such as "first" and "second" are not limited in quantity or execution order, and the words such as "first" and "second" do not limit being certainly different.

When a representative exemplary embodiment is described, a method and/or process may have already been presented in a specific sequence of acts in the specification. However, to an extent that the method or process does not depend on the particular sequence of the steps herein, the method or process should not be limited to the steps in the particular sequence. Those of ordinary skills in the art will understand that other sequences of acts may also be possible. Therefore, the particular sequence of the steps illustrated in the specification should not be interpreted as a limitation on claims. In addition, the claims directed to the method and/or process should not be limited to performing acts according to a written sequence. Those skilled in the art may easily understand that these sequences may be changed, and the changed sequences are still maintained in the spirit and scope of the embodiments of the present disclosure.

An embodiment of the present disclosure provides a joint demapping and decoding method, a decoder, an integrated circuit, a sensor, and the equipment, which may be applied to a communication and sensing system, but are not limited thereto. Under a condition that each component of a received symbol is jointly determined by a plurality of coded bits participating in symbol mapping, during state transition in a decoding process, a likelihood value of each value of a symbol is calculated according to a value of the received symbol, and a branch metric of each state transition branch is obtained based on the likelihood value, thereby avoiding a performance loss caused by calculating a log likelihood ratio of a single component in the received symbol first and then combining to obtain the branch metric, thereby improving decoding performance of a receiver without increasing computational complexity.

First, English abbreviations and full English names of some terms used in this article are given.

Physical layer Service Data Unit: PSDU

Physical layer Header: PHR

Single Error Correction and Double Error Detection: SECDED

Reed-Solomon codes (Reed-Solomon): RS

High repetition Rate Pulse (High Rate Pulse): HRP

Enhanced Relative error Detection (Enhanced Relative Error Detection and Verification): ERDEV

Basic Pulse Repetition Frequency (Base Pulse Repetition Frequency): BPRF

Binary Position Modulation (Binary (burst) Position Modulation): BPM

Binary Phase Shift Keying: BPSK

Quadrature Phase Shift Keying: QPSK

Constraint Length: CL

Log Likelihood Ratio: LLR

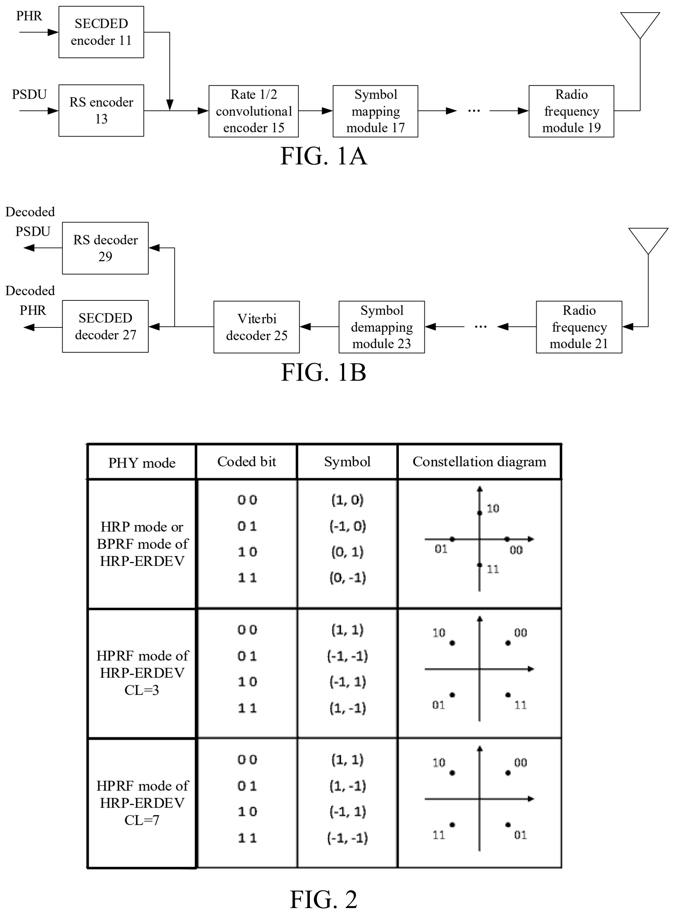

According to the protocol provisions of IEEE Std 802.15. 4 and IEEE Std 802.15. 4z, for a UWB physical layer, convolutional coding with a code rate of 0.5 is adopted for both a PHR and a PSDU needed to be transmitted at a transmitting end, and then specific symbol mapping is performed for subsequent modulation and beam formation. In baseband processing of a receiving end, for data obtained after demodulation, corresponding demapping and convolutional code decoding are needed to be performed. As shown in FIG. 1A, at a transmitting end, the PHR is input to a SECDED encoder 11, the PSDU is input to an RS encoder 13 for encoding, outputs of the SECDED encoder 11 and the RS encoder 13 are both input to a convolutional encoder 15 having a code rate of 0.5 for encoding, and an output of the convolutional encoder 15 is processed by a symbol mapping module 17 and the like, then sent to a radio frequency module 19 for modulation, and then transmitted through an antenna. As shown in FIG. 1B, data of a signal received by the antenna at a receiving end after synchronization, channel equalization, and demodulation in a radio frequency module 21 is subjected to symbol demapping in a symbol demapper 23, and then is decoded by a Viterbi decoder 25, one path is sent to an RS decoder 29 for decoding to obtain a decoded PSDU, and the other path is sent to a SECDED decoder 27 to obtain a decoded PHR.

Symbol mapping rules of the UWB physical layer under different configurations are shown in FIG. 2. When the UWB physical layer is in a HRP mode or works as the HRP-ERDEV equipment in a BPRF mode (shown as the BPRF mode of HRP-ERDEV in the figure), a mode of combining BPM and BPSK modulation (BPM-BPSK) is adopted for a modulation mode. At this time, each symbol is equally divided into two segments, and a pulse with information is sent in only one of the segments. Each modulated symbol contains two bits of information, wherein a first bit indicates a position where a pulse occurs, i.e. in a first half or a second half of the symbol, and a second bit of information determines a phase of the pulse, i.e., +1 or -1; each bit in a symbol may also be referred to as a component of the symbol. When the UWB physical layer works in a Higher Pulse Repetition Frequency (HPRF) mode as the HRP-ERDEV equipment, a modulation mode is similar to QPSK, and rules of symbol mapping are different according to different constraint lengths of convolutional codes (CL = 3 or CL = 7).

As shown in FIG. 2, when the UWB physical layer works in the HRP mode or works as the HRP-ERDEV equipment in the BPRF mode (using BPM-BPSK modulation), a mapping relationship between two coded bits and symbols is: 00 is mapped to symbol (1, 0), 01 is mapped to symbol (-1, 0), 10 is mapped to symbol (0, 1), and 11 is mapped to symbol (0, -1). When the UWB physical layer works in the HPRF mode as HRP-ERDEV and a constraint length of convolutional codes is equal to 3, a mapping relationship between two coded bits and symbols is: 00 is mapped to symbol (1, 1), 01 is mapped to symbol (-1, -1), 10 is mapped to symbol (-1, 1), 11 is mapped to symbol (1, -1). In both cases, a value of each component of a symbol needs to be jointly determined by two coded bits participating in symbol mapping. Correspondingly, when the UWB physical layer works in the HPRF mode as the HRP-ERDEV equipment and a constraint length of convolutional codes is equal to 7, a mapping relationship between two coded bits and symbols is: 00 is mapped to symbol (1, 1), 01 is mapped to symbol (1, -1), 10 is mapped to symbol (-1, 1), 11 is mapped to symbol (-1, -1), and one component (real part) of a symbol is determined by a first coded bit, and the other component (imaginary part) is determined by a second coded bit, and the two are completely independent.

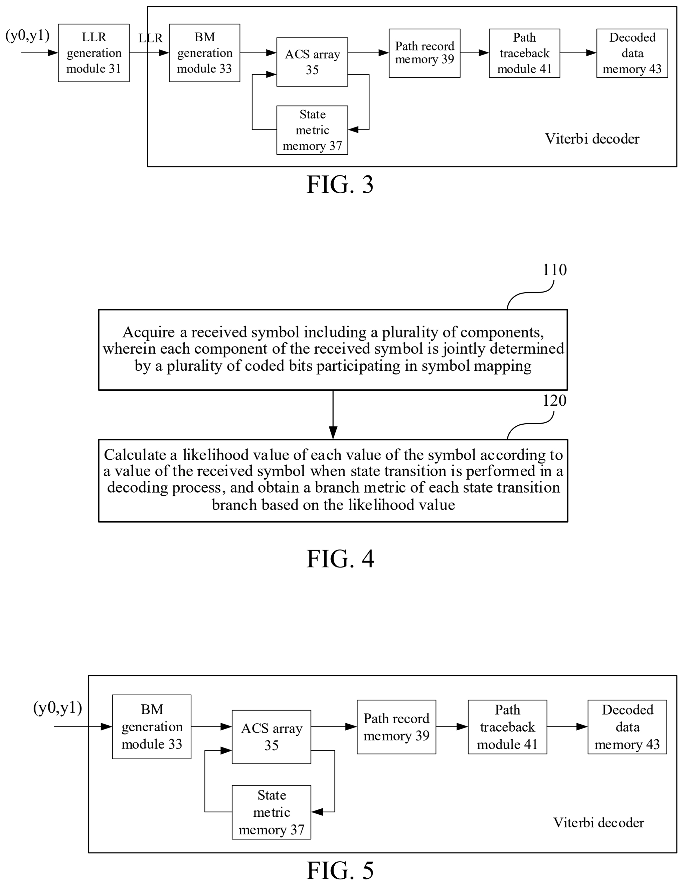

In baseband data processing at the receiving end, referring to FIG. 1B and FIG. 3, an LLR generation module 31 of the symbol demapping module 23 usually calculates a log likelihood ratio, i.e., an LLR, of each coded bit based on a received signal processed by channel equalization, descrambling code, or the like, and outputs a result to the Viterbi decoder for decoding. As shown in FIG. 3, in the Viterbi decoder, a branch metric generation module (branch metric generator) 33 calculates a branch metric based on the LLR to evaluate "good or bad" of different paths, and then performs decoding based on soft information based on an Add-Compare-Select (ACS) array 35, a state metric memory 37, a path record memory 39, a path traceback module 41, a decoded data memory (decoded HB memory) 43, and the like. An exemplary flow of the Viterbi decoder is as follows: receiving signals, i.e., receiving signals transmitted through a channel, wherein these signals may be affected by noise and interference adversely; and path metric calculating, that is, a path metric of each possible path is calculated in a decoding process to evaluate whether different paths are good or bad. This act involves adding and summing branch metrics of each state, and selecting an optimal path; a traceback operation, that is, after processing of all time steps is completed, information stored in the path record memory is used for traceback to determine an optimal decoding path, and this process will track a derived state sequence; outputting coded bits, that is, according to the state sequence obtained by traceback, coded bits sent by the transmitting end are deduced invertedly and output.

In a first embodiment, taking processing of the HRP mode or the BPRF mode of the HRP-ERDEV equipment (BPM-BPSK modulation is adopted for these two modes) as an example, it is assumed that an input signal obtained by a demapping module at the receiving end only contains an influence of Gaussian white noise. Let the two components of a received symbol be $y_0, y_1$, denoted as: $y_0 = x_0 + n_0$, $y_1 = x_1 + n_1$, where $x_0, x_1$ are two components of a transmitted symbol, $n_0, n_1$ are two noise samples that are independently and identically distributed. Coded bits corresponding to the transmitted symbol are denoted as $b_0$, $b_1$, their log likelihood ratios are defined as follows.

$$L_0 = \log \Pr(b_0 = 0|y_0 y_1) - \log \Pr(b_0 = 1|y_0 y_1)$$

$$L_1 = \log \Pr(b_1 = 0|y_0 y_1) - \log \Pr(b_1 = 1|y_0 y_1)$$

Herein, $\Pr(b_0 = 0|y_0 y_1)$ represents a probability that $b_0$ is 0, in the case of given $y_0$ and $y_1$. $\Pr(b_0 = 1|y_0 y_1)$ represents a probability that $b_0$ is 1, in the case of given $y_0$ and $y_1$; $\Pr(b_1 = 0|y_0 y_1)$ represents a probability that $b_1$ is 0, in the case of given $y_0$ and $y_1$, $\Pr(b_1 = 1|y_0 y_1)$ represents a probability that $b_1$ is 1, in the case of given $y_0$ and $y_1$.

Posterior probabilities in the log likelihood ratios may be transformed into conditional probabilities according to the Bayes rule and an assumption that 0 and 1 occur in coded bits with an equal probability.

$$L_0 = \log \Pr(y_0 y_1|b_0 = 0) - \log \Pr(y_0 y_1|b_0 = 1)$$

$$L_1 = \log \Pr(y_0 y_1|b_1 = 0) - \log \Pr(y_0 y_1|b_1 = 1)$$

Since $y_0, y_1$ are jointly deterined by $b_0, b_1$, combined with a mapping relationship between coded bits and symbols under BPM-BPSK modulation shown in FIG. 2, the conditional probabilities are written as follows.

$$\begin{aligned} \Pr(y_0 y_1|b_0 = 0) &= \frac{1}{2}\Pr(y_0 y_1|b_0 b_1 = 00) + \frac{1}{2}\Pr(y_0 y_1|b_0 b_1 = 01) \\ &= \frac{1}{2}\Pr(y_0|x_0 = 1) \cdot \Pr(y_1|x_1 = 0) + \frac{1}{2}\Pr(y_0|x_0 = -1) \cdot \Pr(y_1|x_1 = 0) \end{aligned}$$

$$\begin{aligned} \Pr(y_0 y_1|b_0 = 1) &= \frac{1}{2}\Pr(y_0 y_1|b_0 b_1 = 10) + \frac{1}{2}\Pr(y_0 y_1|b_0 b_1 = 11) \\ &= \frac{1}{2}\Pr(y_0|x_0 = 0) \cdot \Pr(y_1|x_1 = 1) + \frac{1}{2}\Pr(y_0|x_0 = 0) \cdot \Pr(y_1|x_1 = -1) \end{aligned}$$

$$\begin{aligned} \Pr(y_0 y_1|b_1 = 0) &= \frac{1}{2}\Pr(y_0 y_1|b_0 b_1 = 00) + \frac{1}{2}\Pr(y_0 y_1|b_0 b_1 = 10) \\ &= \frac{1}{2}\Pr(y_0|x_0 = 1) \cdot \Pr(y_1|x_1 = 0) + \frac{1}{2}\Pr(y_0|x_0 = 0) \cdot \Pr(y_1|x_1 = 1) \end{aligned}$$

$$\begin{aligned} \Pr(y_0 y_1|b_1 = 1) &= \frac{1}{2}\Pr(y_0 y_1|b_0 b_1 = 01) + \frac{1}{2}\Pr(y_0 y_1|b_0 b_1 = 11) \\ &= \frac{1}{2}\Pr(y_0|x_0 = -1) \cdot \Pr(y_1|x_1 = 0) + \frac{1}{2}\Pr(y_0|x_0 = 0) \cdot \Pr(y_1|x_1 = -1) \end{aligned}$$

The above equations and a Gaussian probability density function are brought into calculation of a log likelihood ratio, and following results are obtained.

$$L_0 = \log\left(\exp\left(-\frac{(y_0-1)^2+y_1^2}{2\sigma^2}\right) + \exp\left(-\frac{(y_0+1)^2+y_1^2}{2\sigma^2}\right)\right)$$
$$-\log\left(\exp\left(-\frac{(y_1-1)^2+y_0^2}{2\sigma^2}\right) + \exp\left(-\frac{(y_1+1)^2+y_0^2}{2\sigma^2}\right)\right)$$

$$L_1 = \log\left(\exp\left(-\frac{(y_0-1)^2+y_1^2}{2\sigma^2}\right) + \exp\left(-\frac{(y_1-1)^2+y_0^2}{2\sigma^2}\right)\right)$$
$$-\log\left(\exp\left(-\frac{(y_0+1)^2+y_1^2}{2\sigma^2}\right) + \exp\left(-\frac{(y_1+1)^2+y_0^2}{2\sigma^2}\right)\right)$$

According to an approximation relationship:log(exp(x) + exp(y)) ≈ max(x, y), expressions of the log likelihood ratios may be further simplified (an error of this approximation is very small and there is almost no numerical influence) as follows.

$$L_0 = \frac{|y_0| - |y_1|}{\sigma^2}$$

$$L_1 = \frac{y_0 + y_1}{\sigma^2}$$

Herein, $\sigma$ represents a standard deviation of Gaussian distribution.

The LLR generation module 31 in FIG. 3 (corresponding to the symbol demapping module 23 in FIG. 1B) performs the above calculation. However, this formula cannot be used to invertedly deduce the received signals $y_0$ and $y_1$. This also shows that a method of demapping and decoding step by step has a performance loss. In the Viterbi decoder of FIG. 3, every two LLR inputs correspond to one state transition, and four branch metric values need to be calculated, respectively corresponding to likelihood values of the state transition whose output is 00/01/10/11.

$$\gamma_{00} = L_0 + L_1, \quad \gamma_{01} = L_0 - L_1, \quad \gamma_{10} = -L_0 + L_1, \quad \gamma_{11} = -L_0 - L_1.$$

According to these branch metric values, the Viterbi decoder continuously updates a path metric, and finally finds a decoding path with a largest path metric, and obtains an optimal decoding result.

In the above embodiment, a method is adopted, in the method, a log likelihood ratio of each coded bit is calculated first, and then log likelihood ratios are combined in branch metric calculation of the decoder. A default assumption thereof is that two bits corresponding to each state transition are independent of each other. However, from the perspective of demapping, characteristics of symbol mapping is not considered in this embodiment, that is, two coded bits corresponding to a same symbol are related, and the method of demapping and decoding step by step adopted in this embodiment will bring a performance loss. In a case that in the HPRF mode of the HRP-ERDEV equipment and a constraint length of convolutional codes is equal to 3, two coded bits corresponding to a same symbol are also related, and there is also a performance loss problem.

Therefore, an embodiment of the present disclosure proposes a joint demapping and decoding method, as shown in FIG. 4, including following acts.

In act 110, a received symbol including a plurality of components is acquired, wherein each component of the received symbol is jointly determined by a plurality of coded bits participating in symbol mapping.

In act 120, when state transition is performed in a decoding process, according to a value of the received symbol, a likelihood value of each value of the symbol is calculated, and a branch metric of each state transition branch is obtained based on the likelihood value.

In an example of the present embodiment, one symbol is generated at each state transition of the decoding process, and the likelihood value of each value of the symbol is calculated according to the value of the received symbol when the state transition is performed in the decoding process, including calculating the likelihood value of each value of the symbol according to the value of the received symbol at each state transition of the decoding process.

In this method, when a result of symbol mapping needs to be jointly determined by two coded bits, when the receiving end uses a Viterbi decoder for convolutional decoding, a likelihood value of state transition may be directly calculated by a distance between the received symbol and a constellation point, that is, joint demapping and decoding are carried out. Since the demapping and convolutional decoding at the receiving end are processed based on a mapped symbol, that is, processing of two bits, performance of a receiver may be significantly improved compared with processing in a unit of a single bit. The method of the present embodiment may be used in a UWB receiver. Since convolutional codes with a code rate of 0.5 is used for the UWB physical layer, each original input bit exactly corresponds to an output of two coded bits, that is, a position of one symbol is determined.

Based on a symbol mapping mode specified by the UWB physical layer, in the HRP mode or the BPRF mode of the HRP-ERDEV equipment (BPM-BPSK modulation is adopted for these two modes), or in the HPRF mode of the HRP-ERDEV equipment and when a constraint length of convolutional codes is equal to 3, there is characteristics that a result of symbol mapping is jointly determined by two coded bits, an embodiment of the present disclosure proposes a method of joint demapping and convolutional decoding at a receiving end. This method may significantly improve decoding performance of the receiver without increasing computational complexity.

Therefore, the embodiment of the present disclosure proposes that when the Viterbi decoder calculates a branch metric, a likelihood value of occurrence of a certain symbol is considered, instead of separately calculating likelihood values of occurrence of two bits and then merging them. Specifically, a branch metric is defined as a likelihood value of a corresponding symbol to quantify the possibility of occurring of a state transition.

Taking BPM-BPSK modulation as an example, four branch metrics may be defined as follows.

$$\gamma_{00} = \log \Pr\left(y_0 y_1 | b_0 b_1 = 00\right) = -\frac{(y_0 - 1)^2 + y_1^2}{2\sigma^2} - \log\left(\sigma\sqrt{2\pi}\right)$$

$$\gamma_{01} = \log \Pr\left(y_0 y_1 | b_0 b_1 = 01\right) = -\frac{(y_0 + 1)^2 + y_1^2}{2\sigma^2} - \log\left(\sigma\sqrt{2\pi}\right)$$

$$\gamma_{10} = \log \Pr\left(y_0 y_1 | b_0 b_1 = 10\right) = -\frac{(y_1 - 1)^2 + y_0^2}{2\sigma^2} - \log\left(\sigma\sqrt{2\pi}\right)$$

$$\gamma_{11} = \log \Pr\left(y_0 y_1 | b_0 b_1 = 11\right) = -\frac{(y_1 + 1)^2 + y_0^2}{2\sigma^2} - \log\left(\sigma\sqrt{2\pi}\right)$$

In a Viterbi decoding process, updating of a path metric of each state involves selecting from two arrival paths. Since a constant summation term and a normal multiplier in branch metric calculation do not change with state or time, they will not affect path selection, so they may be simplified to obtain as follows.

$$\gamma_{00} = -(y_0 - 1)^2 - y_1^2$$

$$\gamma_{01} = -(y_0 + 1)^2 - y_1^2$$

$$\gamma_{10} = -(y_1 - 1)^2 - y_0^2$$

$$\gamma_{11} = -(y_1 + 1)^2 - y_0^2$$

Adding $\left(y_0^2 + y_1^2 + 1\right)$ to each item and removing a common factor 2 will not affect the path selection, thus obtaining as follows.

$$\gamma_{00} = y_0, \quad \gamma_{01} = -y_0, \quad \gamma_{10} = y_1, \quad \gamma_{11} = -y_1.$$

In an exemplary embodiment of the present disclosure, one symbol is generated at each state transition of the decoding process, and a mapping relationship between coded bits and symbols is: 00 is mapped to symbol (1, 0), 01 is mapped to symbol (-1, 0), 10 is mapped to symbol (0, 1), 11 is mapped to symbol (0, -1).

A likelihood value of each value of the symbol is calculated through a following formula.

$$\gamma_{00} = y_0, \quad \gamma_{01} = -y_0, \quad \gamma_{10} = y_1, \quad \gamma_{11} = -y_1$$

Herein, $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $y_{11}$ represents a likelihood value with a value of a symbol of 11, $y_0$ is a first component in the received symbol, $y_1$ is a second component in the received symbol.

The method of the present embodiment may be applied to an ultra-wideband wireless communication system; a physical layer of the ultra-wideband wireless communication system works in the HRP mode or works in the BPRF mode as the HRP-ERDEV equipment; a BPM-BPSK modulation mode is adopted for the physical layer of the ultra-wideband wireless communication system, and every two coded bits are mapped to one symbol.

The Viterbi decoder of the present embodiment calculates a likelihood value of each state transition as a branch metric according to a received signal. The branch metric is summed with a current path metric of each state, and one path with a larger sum among two paths reaching each state is selected to update the path metric of each state. When an end of a path is reached, the decoder obtains a path with a largest path metric, and a decoded bit sequence may be obtained by backtracking, which corresponds to a decoded maximum likelihood solution.

Similarly, when the UWB physical layer works in the HPRF mode as the HRP-ERDEV equipment and a constraint length of convolutional codes is equal to 3, following formulas may be obtained by calculation.

$$\gamma_{00} = y_0 + y_1, \quad \gamma_{01} = -y_0 - y_1, \quad \gamma_{10} = -y_0 + y_1, \quad \gamma_{11} = y_0 - y_1.$$

It may be seen that in a joint demapping and decoding solution, calculation of branch metrics is very concise.

In another exemplary embodiment of the present disclosure, one symbol is generated at each state transition of the decoding process, and a mapping relationship between coded bits and symbols is: 00 is mapped to symbol (1, 1), 01 is mapped to symbol (-1, -1), 10 is mapped to symbol (-1, 1), 11 is mapped to symbol (1, -1).

A likelihood value of each value of the symbol is calculated through a following formula.

$$\gamma_{00} = y_0 + y_1, \quad \gamma_{01} = -y_0 - y_1, \quad \gamma_{10} = -y_0 + y_1, \quad \gamma_{11} = y_0 - y_1$$

Herein, $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $y_{11}$ represents a likelihood value with a value of a symbol of 11, $y_0$ is a first component in the received symbol, $y_1$ is a second component in the received symbol.

The method of the present embodiment may be applied to an ultra-wideband wireless communication system, a physical layer of the ultra-wideband wireless communication system works in the HPRF mode as the HRP-ERDEV equipment and a constraint length of convolutional codes is equal to 3, and every two coded bits are mapped to one symbol.

In an exemplary embodiment of the present disclosure, the obtaining the branch metric of each state transition branch based on the likelihood value includes: taking a calculated likelihood value of each value of the symbol as a branch metric of one corresponding state transition branch.

An implementation block diagram of joint demapping and decoding proposed in this solution is shown in FIG. 5. Compared with FIG. 3, main differences are that the LLR calculation module at a front end of the decoder is removed, so that the decoder directly receives a demodulated signal, and the Branch Metric (BM) calculation module is modified.

An effect thereof may be verified through a simulation experiment: FIG. 5 shows change of a Block Error Rate (BLER) with a signal-to-noise ratio of a test case. In this test case, a PSDU with a length of 20 Bytes is used, a modulation mode is BPM-BPSK, and a channel model is an additive Gaussian white noise channel. In the figure, a line marked with BPM-BPSK and LLR corresponds to a solution of the first embodiment, and a line marked with BPM-BPSK and symb corresponds to a solution of the embodiment of the present disclosure. It may be seen that at a working point of BLER = 1%, the solution achieves a performance gain of close to 2 dB compared with the existing technology. If a symbol mapping mode is independent for two coded bits (for example, when the UWB physical layer works in the HPRF mode as the HRP-ERDEV equipment and a constraint length of convolutional codes is equal to 7), the existing technology and the present solution are equivalent, and its decoding performance corresponds to a line marked with BPSK in the figure. A line marked with BPM-BPSK, symb, list-2 in the figure are obtained by using a list algorithm (a size is set to 2) for the Viterbi decoder based on the present solution. It may be seen that decoding performance has been further improved, indicating that the present solution may be used together with other optimization algorithms.

For a symbol mapping mode satisfying a condition that "existing symbol components are jointly determined by a plurality of coded bits participating in mapping rather than separately", the joint demapping and decoding solution proposed in the present solution avoids a performance loss caused by first calculating a log likelihood ratio of a single component in a received symbol and then merging to obtain the branch metric, and both can achieve a performance gain compared with the existing technology. In the above embodiment, there is a matching relationship between a code rate of the Viterbi decoder and a modulation mode: convolutional codes with a code rate of 0.5 generate two coded bits at each state transition, which can just be mapped to one modulated symbol. However, that present disclosure is not limit to a condition that "convolutional codes generate one symbol at each state transition".

When there is a multiple relationship between a quantity of coded bits corresponding to each original bit and a quantity of coded bits contained in each symbol, for example, in one example, the quantity of coded bits contained in each symbol is equal to N times of the quantity of coded bits corresponding to one original bit, that is, one symbol is generated at N times of state transitions, $N \geq 2$, then a design similar to Radix-4 may be adopted for the Viterbi decoder, N times of state transitions (such as two state transitions) are processed at each step, and N times of state transitions are merged into one time, while a method based on a likelihood value of a symbol of this solution may directly be used for calculating a branch metric, and a likelihood value of each value of the symbol corresponds to a branch metric of each branch of this state transition.

However, in another example, if a quantity of coded bits corresponding to one original bit is equal to M times of a quantity of coded bits contained in each symbol, that is, M symbols are generated at one-time state transition, $M \geq 2$, likelihood values of M symbols (such as two symbols) may be combined when calculating a branch metric, for example, at each state transition in a decoding process, a likelihood value of each value of M symbols are respectively calculated according to values of M received symbols, and then these likelihood values are accumulated to obtain a branch metric of each state transition branch. In summary, the embodiment of the present disclosure may be used in a baseband receiver whose modulation and coding mode satisfies the above condition, and an application in a UWB system is only one example, and may also be used in other communication and sensing systems.

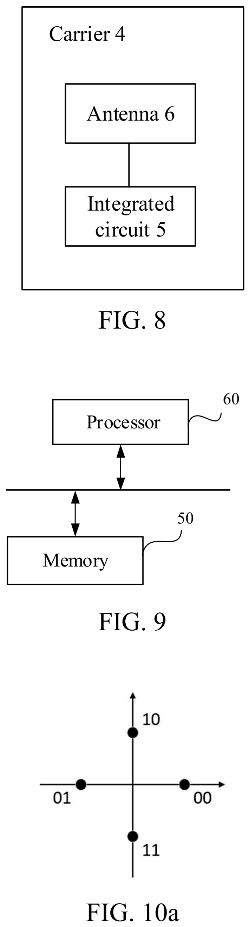

An embodiment of the present disclosure also provides a joint demapping and decoding apparatus, which, as shown in FIG. 9, includes a memory 50 and a processor 60, wherein the memory 50 stores a computer program, wherein the joint demapping and decoding method described in any embodiment of the present disclosure can be achieved when the processor 60 executes the computer program. The processor of the present embodiment may be a general-purpose processor, including a Central Processing Unit (CPU), a Network Processor (NP), a microprocessor, or the like, or may be other conventional processors, or the likej. The processor may also be a Digital Signal Processor (DSP), an Application Specific Integrated Circuit (ASIC), an Field Programmable Gate Array (FPGA), discrete logic or another programmable logic device, a discrete gate or transistor logic device, a discrete hardware component; it may also be a combination of the above-described devices. That is, the processor of the above embodiments may be any processing device or combination of devices that implements methods, acts, and logical block diagrams disclosed in the embodiments of the present disclosure. If the embodiments of the present disclosure are implemented in part in software, instructions for the software may be stored in a suitable non-volatile computer-readable storage medium, and the instructions may be executed in hardware using one or more processors to implement methods of the embodiments of the present disclosure.

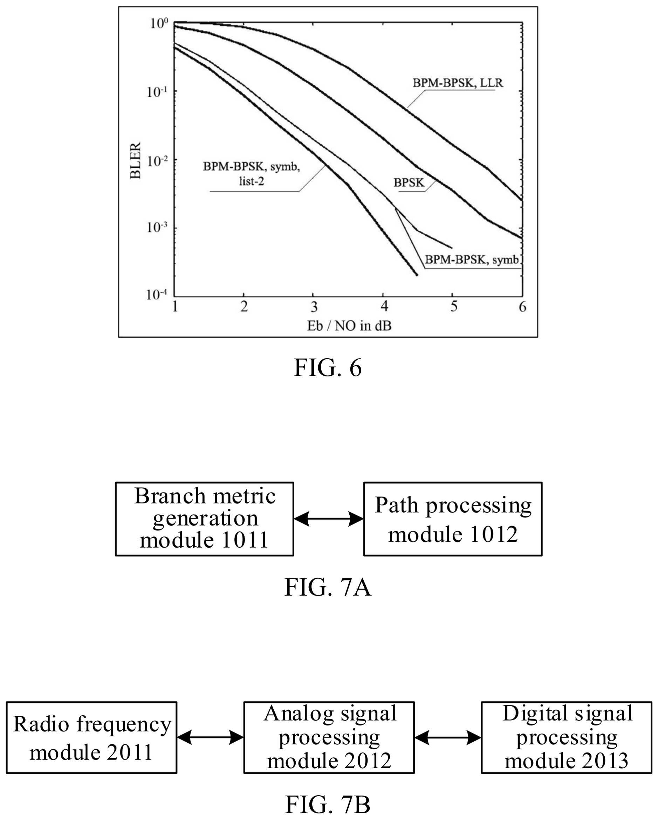

An embodiment of the present disclosure also provides a decoder, as shown in FIG. 7A, including a branch metric generation module **1011** and a path processing module 1012, wherein:

the branch metric generation module 1011 is configured to obtain a received symbol including a plurality of components from an input end, obtain a branch metric of each state transition branch according to the joint demapping and decoding method according to any embodiment of the present disclosure, and output the branch metric of each state transition branch to the path processing module;

the path processing module 1012 is configured to update and record a path metric of each state based on the branch metric, determine a decoding path having a largest path metric by backtracking when an end point of a decoding path is reached, and obtain a decoded coded bit sequence based on a state sequence contained in the determined decoding path.

In an exemplary embodiment of the present disclosure, the decoder is a Viterbi decoder, and the Viterbi decoder decodes convolutional codes having a code rate of 0.5.

An embodiment of the present application also provides an integrated circuit, as shown in FIG. 7B, the integrated circuit includes a radio frequency module 2011, an analog signal processing module 2012, and a digital signal processing module 2013 sequentially connected, wherein

the radio frequency module 2011 is configured to generate and transmit an electromagnetic wave signal, and to receive an electromagnetic wave signal;

the analog signal processing module 2012 is configured to perform down-frequency processing on the received electromagnetic wave signal to obtain an intermediate frequency signal; and

the digital signal processing module 2013 is configured to perform analog-to-digital conversion on the intermediate frequency signal to obtain a digital signal and process the data signal; wherein the digital signal processing module further includes the decoder according to any embodiment of the present disclosure.

In an exemplary embodiment of the present disclosure, the integrated circuit is a chip applied to an ultra-wideband system.

In some optional embodiments of the present disclosure, the integrated circuit may be of an Antenna-In-Package (AiP) chip structure, an Antenna-On-Package (AoP) chip structure, an Antenna-On-Chip (AoC) chip structure, a Radiator on Package (RoP) chip structure, or the like. Among them, RoP is by setting a radiation structure (Radiator) on a chip package, an air waveguide structure surrounded by solder balls around the radiation structure may be formed, that is, a Radio Frequency (RF) signal generated by a chip may be transmitted to an external antenna via an air cavity waveguide structure surrounded by the solder balls and air waveguide built in a Printed Circuit Board (PCB) board through the above radiation structure to radiate to a target region.

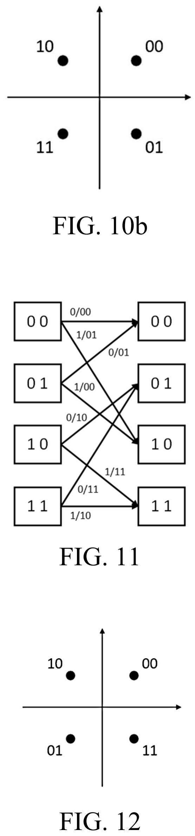

An embodiment of the present disclosure also provides an electromagnetic wave device, as shown in FIG. 12, including: a carrier 4; the integrated circuit 5 according to any embodiment of the present disclosure disposed on the carrier 4; and an antenna 6 disposed on the carrier 4 and integrated with the integrated circuit 5 as an integral device (i.e., at this time, the antenna may be an antenna disposed in a structure such as AiP, AoP, AoC, or RoP) or the antenna 6 and the integrated circuit 5 are disposed separately; wherein the integrated circuit 5 is connected with the antenna 6 (that is, at this time, the antenna may be an antenna disposed in a structure such as AiP, AoP, AoC, or RoP), and is used for transmitting and/or receiving the electromagnetic wave signal. Herein, the carrier may be a Printed Circuit Board (PCB), and the integrated circuit and the antenna are routed through the PCB.

The electromagnetic wave device may achieve functions such as target detection and/or communication by transmitting and receiving electromagnetic wave signals to provide detection target information and/or communication information to the equipment body, thereby assisting or even controlling operation of the equipment body.

An embodiment of the present disclosure also provides the terminal equipment, as shown in FIG. 8, including: the equipment body; and the electromagnetic wave device as described in any one embodiment of the present disclosure disposed on the equipment body; wherein the electromagnetic wave device is configured to perform target detection and/or communication to provide reference information for operation of the equipment body.

Exemplarily, on a basis of the above-described embodiments, in one optional embodiment of the present disclosure, an electromagnetic wave device may be disposed outside the equipment body or inside the equipment body, and in other optional embodiments of the present disclosure, an electromagnetic wave device may be partially disposed inside the equipment body and partially disposed outside the equipment body. The embodiments of the present disclosure are not limited thereto, it depends actual situation.

In an optional embodiment, the above equipment body may be components and products applied to fields such as smart cities, smart houses, transportation, smart homes, consumer electronics, security monitoring, industrial automation, in-cabin detection (such as smart cockpits), medical devices and health care. For example, the equipment body may be the smart transportation device (such as an automobile, a bicycle, a motorcycle, a ship, a subway, a train, etc.), a security device (such as a camera), a liquid level/flow rate detection device, a smart wearable device (such as a bracelet, glasses, etc.), a smart home device (such as a sweeping robot, a door lock, a television, an air conditioner, a smart light, etc.), various communication devices (such as mobile phones, tablet computers, etc.), as well as a road gate, a smart traffic light, a smart sign, a traffic camera, and various industrial mechanical arms (or robots), etc. The equipment body may also be various instruments for detecting vital feature parameters and various devices equipped with the instruments, such as vital feature detection in automobile cabins, indoor personnel monitoring, intelligent medical devices, consumer electronic devices, car digital keys, empty mice, and so on.

An embodiment of the present disclosure also provides a non-transitory computer-readable storage medium storing a computer program, wherein when the computer program is executed by a processor, the joint demapping and decoding method according to any one embodiment of the present disclosure can be achieved.

Taking UWB as an example, related technical solutions of the present disclosure will be described in detail below.

Herein, decoding may also be referred to as deciphering code, and demapping may also be referred to as inverse decoding.

In a UWB technology, a High Rate Pulse (HRP) refers to a high rate pulse mode. It is a mode in UWB communication and corresponds to a Low Rate Pulse (LRP), which is a a low rate pulse mode. The HRP mode is used in UWB communication to achieve high-rate data transmission. It uses a relatively high pulse repetition rate and transmits information by sending narrow pulses of a nanosecond level. These narrow pulses have a very wide bandwidth, may carry a large amount of information, and may provide better performance in a multipath environment.

In a physical layer technology of UWB, the HRP mode defines different frequency bands and channels to meet different application requirements. For example, HRP UWB may define a Sub GHz frequency band, a Low Band frequency band, and a High Band frequency band, etc., and provide multiple channels for selection within each frequency band. Some of these channels support greater bandwidths to achieve higher data transmission rates.

**EP 4 716 127 A1**

HRP UWB PHY refers to a High Rate Pulse Ultra-Wideband physical layer. HRP UWB PHY is based on IEEE 802.15. 4a/z and other standards, and uses narrow pulses of a nanosecond level for data transmission. It defines different frequency bands and channels to meet various application requirements, and has advantages of low system complexity, a low power spectral density of a transmitted signal, insensitivity to channel fading, a low interception ability, and high positioning accuracy, etc. It is especially suitable for high-speed wireless access and precise positioning in dense multipath places such as indoors.

In addition, HRP UWB PHY also supports higher pulse repetition frequencies to achieve higher data transmission rates. Moreover, in order to enhance security of a ranging device, a Scrambling Timestamp Sequence (STS) and other technologies are introduced.

In the IEEE 802.15. 4z standard, two modes, a Base Pulse Repetition Frequency (BPRF) and a Higher Pulse Repetition Frequency (HPRF), are also defined for HRP-ERDEV (Enhanced Ranging Device).

In UWB communication, particularly in a High Rate Pulse (HRP) UWB mode, a BPM-BPSK or BPSK modulation strategy may be employed to transmit a coded bit sequence. Among them, Binary (burst) Position Modulation (BPM) modulation is a position modulation mode, in which information is represented by a position of a pulse (burst), that is, a position of each pulse may correspond to a specific data symbol or bit combination. Binary Phase Shift Keying (BPSK) modulation is a phase modulation mode, in which information is represented by changing a phase of a carrier wave. In BPSK, there are usually two phases, and each phase represents a binary value (0 or 1).

When the above two modulation modes are used in combination, that is, in BPM-BPSK joint modulation, the two modulation modes may act together on a coded bit sequence to generate a composite modulated signal. That is, this signal includes both pulse position information provided by the BPM and phase information provided by the BPSK to provide a higher data transmission rate and/or better anti-interference ability, that is, it may effectively improve an efficiency and reliability of data transmission. In practical applications, this composite modulation strategy may require a specific reception algorithm to correctly decode and recover an original bit sequence. Moreover, performance of a system will also be affected by a channel condition, noise interference, and other factors adversely.

In a UWB technology, a modulation constellation diagram is a graphical representation used to represent positions of different modulated symbols in signal space. Each constellation point corresponds to a specific symbol, and the symbol in turn is represented by a certain quantity of bits.

Gray code is a binary number system in which consecutive values differ by only one bit. In communication, a constellation diagram using Gray code means that there is a difference of only one bit between adjacent constellation points, which helps to reduce errors caused by noise or interference, because only one bit will be wrong when a symbol is misjudged as an adjacent symbol.

Since a modulation constellation diagram used in UWB communication is not arranged in Gray code, adjacent constellation points may differ in more than one bit, which usually increases an error rate of such as original bits, in communication. That is, if the modulation constellation diagram is not Gray coded, i.e., "non-Gray", then adjacent constellation points may differ in more than one bit. This means that when a misjudgment occurs, multiple bits may go wrong, thus increasing severity of an error.

For a communication device using a mode such as BPM-BPSK joint modulation, a modulated constellation diagram is in a non-Gray format, and decoding based on bit-by-bit soft information may cause increasing of an error rate of subsequent data transmission and decoding. Although some error correction mechanisms may be used to improve reliability of transmission and reduce the error rate of decoding to a certain extent, error correction results still cannot meet current product needs, and further improvement is urgently needed.

For example, for the HRP-ERDEV equipment in a BPRF mode in the HRP UWB equipment, for all of them, a coded bit sequence may be modulated by adopting a mode of combining binary position modulation and binary phase shift keying, that is, BPM-BPSK joint modulation may be adopted, so that a modulation constellation diagram generated after modulation is in a non-Gray format, which means that adjacent constellation points may differ in more than one bit. This usually increases an error rate of original bits when decoding because a difference between adjacent symbols is relatively large. In addition, for the HRP-ERDEV equipment in a HPRF mode, convolutional codes with a constraint length of 3 are used, its modulation mapping is also of non-Gray, which will accordingly increase an error rate of subsequent decoding.

For a UWB, convolutional codes with a rate of 0.5 are used for channel coding to correct errors, so as to improve reliability of modulated data transmission. At the receiving end, decoding performance may also be improved by using a soft Viterbi decoding algorithm for decoding, that is, using soft information (such as a log likelihood ratio, that is, LLR for short) of a received signal. However, for the above modulation (non-Gray code)-decoding (Viterbi based on bit-by-bit LLR) mode, since for a standard LLR calculation method, inter-symbol correlation introduced by non-Gray symbol mapping is not utilized, some information helpful for decoding may be lost, which further causes a decoding error rate to deteriorate, causes sensitivity of a system to decrease, thus failing to meet current requirements of high-precision information transmission.

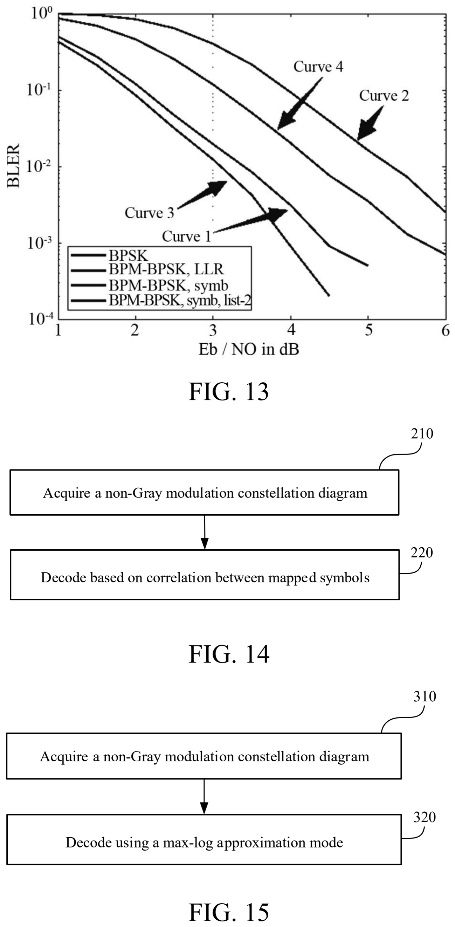

In some optional embodiments of the present disclosure, a joint demapping and decoding method is proposed, as shown in FIG. 14, including: act 210, acquiring a non-Gray modulation constellation diagram, that is, acquiring a received symbol including a plurality of components, wherein each component of the received symbol is jointly determined by a plurality of coded bits participating in symbol mapping; and act 220, decoding based on correlation between mapped symbols.

In one example of the present embodiment, the decoding based on the correlation between the mapped symbols includes: calculating a posterior probability based on a correlation level between the mapped symbols for decoding.

The method of the above-described embodiment of the present disclosure may be applied to a UWB PHY layer, and by effectively utilizing inter-symbol correlation introduced by non-Gray symbol mapping, better performance may be achieved than LLR-based decoding without increasing complexity. That is, through a joint operation of demapping and decoding, accuracy of decoding may be improved without increasing complexity of a system, thus enhancing reliability of a communication system.

Exemplarily, for a BPM-BPSK modulation model, it may be: b represents a convolutional encoded bit, let x represents a modulated symbol, and y represents a received symbol, and a corresponding convolutional coding pair ($b_0$, $b_1$) are non-Gray mapped to a modulated symbol pair ($x_0$, $x_1$), a specific mapping relationship may be shown in Table 1 below (wherein a power of each symbol is unit power).

Table 1

| ($b_0$, $b_1$) | ($x_0$, $x_1$) |
| --- | --- |
| (0, 0) | (1, 0) |
| (0, 1) | (-1, 0) |
| (1, 0) | (0, 1) |
| (1, 1) | (0, -1) |

A constellation diagram corresponding to the above Table 1 may be referred to what shown in FIG. 10a. Compared with a Gray code constellation diagram shown in FIG. 10b, at this time, adjacent constellation points of a non-Gray code constellation diagram in FIG. 10a may be different in more than one bit (for example, there is a difference of two bits between 00 and 11).

It should be noted that the modulated symbol pair ($x_0$, $x_1$) is determined jointly by the corresponding convolutional encoded pair ($b_0$, $b_1$), instead of being mapped from ($b_0$) to ($x_0$) and from ($b_1$) to ($x_1$) separately.

For an Additive White Gaussian Noise (AWGN) channel, in a corresponding received symbol pair ($y_0$, $y_1$), $y_0 = x_0 + n_0$, $y_1 = x_1 + n_1$. Among them, an energy of each bit (Energy per bit) is 1/2, that is, an energy sum of two bits is 1; $n_0$, $n_1$ are noise samples, which are mutually independent Gaussian distributions based on $\sigma^2$ (i.i.d. Gaussian with variance $N(0, \sigma^2)$).

That is, for the modulation model of BPM-BPSK, pairs of convolutional encoded bits ($b_0$, $b_1$) are mapped to a two-dimensional modulated symbol ($x_0$, $x_1$). Since the mapping is non-Gray, it means that adjacent symbols may differ in multiple bits. In addition, if a mapped modulated symbol is sent through an additive white Gaussian noise channel, noise will be added at the receiving end, that is, the received symbol pair ($y_0$, $y_1$) is a sum of the two-dimensional modulated symbol ($x_0$, $x_1$) and noise ($n_0$, $n_1$) and the energy per bit is related to a noise variance. Since in an actual receiver system, after baseband signal processing of a previous stage, such as synchronization, channel estimation, channel equalization, and other operations, a channel used by a demapping and decoding module may be approximately regarded as an additive white Gaussian noise channel, therefore, in an embodiment of the present disclosure, another demodulation and modulation method is proposed after research on creativity based on the model, which may be specifically as follows.

When decoding a BPM-BPSK modulated signal, a Log Likelihood Ratio (LLR) value generated by a demodulator may also be used as an input of a soft Viterbi decoder. Since the LLR value may be used as a measure of likelihood that each coded bit is "0" or "1", that is, for a BPM-BPSK modulation model in a UWB, by introducing the LLR value into a decoding process, correlation between symbols may be introduced in the decoding process, so that the decoder may more accurately estimate a value of each coded bit, thereby improving decoding performance.

Exemplarily, an expression of the above LLR may be as follows.

$$L_i = \log \Pr\left(b_i = 0|y_0 y_1\right) - \log \Pr\left(b_i = 1|y_0 y_1\right), i = 0,1$$

Based on the above formula, by using the Bayes rule and the equally probable input assumption, the following may be further obtained.

$$L_i = \log \Pr\left(y_0 y_1|b_i = 0\right) - \log \Pr\left(y_0 y_1|b_i = 1\right) = 1$$

Therefore, for a BPM-BPSK joint modulation mode, the following may be obtained based on the definition of conditional probability and independent and identically distributed Gaussian noise (i.i.d. Gaussian noise).

$$L_0 = \log\left(\exp\left(-\frac{(y_0-1)^2+y_1^2}{2\sigma^2}\right) + \exp\left(-\frac{(y_0+1)^2+y_1^2}{2\sigma^2}\right)\right) - \log\left(\exp\left(-\frac{y_0^2+(y_1-1)^2}{2\sigma^2}\right) + \exp\left(-\frac{y_0^2+(y_1+1)^2}{2\sigma^2}\right)\right);$$

$$L_1 = \log\left(\exp\left(-\frac{(y_0-1)^2+y_1^2}{2\sigma^2}\right) + \exp\left(-\frac{y_0^2+(y_1-1)^2}{2\sigma^2}\right)\right) - \log\left(\exp\left(-\frac{(y_0+1)^2+y_1^2}{2\sigma^2}\right) + \exp\left(-\frac{y_0^2+(y_1+1)^2}{2\sigma^2}\right)\right);$$

Herein, $L_i$ represents a value of the LLR, $L_0$ represents a value of the LLR when a coded bit is "0", $L_1$ represents a value of the LLR when a coded bit is "1".

That is, for BPM-BPSK modulation, since each symbol is jointly determined by two bits, there are two LLR values $L_0$ and $L_1$, respectively corresponding to two encoded bits, while in a process of acquiring the above LLR values $L_i$, a received received symbol pair $(y_0, y_1)$, an energy 1/2 of each bit, a noise variance, and a possible value of a coded bit, and other factors are introduced, thus achieving introducing correlation between symbols in a decoding process, so that a decoder may more accurately estimate a value of a coded bit, thereby improving performance of a communication system.

In addition, in some optional embodiments, calculation of an LLR may also be greatly simplified without sacrificing performance by using max-log approximation. Among them, a formula of the max-log approximation is as follows.

$$\log\left(\exp\left(x\right) + \exp\left(y\right)\right) \approx \max(x, y)$$

That is, for the BPM-BPSK joint modulation mode, a formula based on the above value $L_i$ of the LLR may be correspondingly simplified as follows.

$$L_0 = \frac{|y_0| - |y_1|}{\sigma^2}, \quad L_1 = \frac{y_0 + y_1}{\sigma^2}$$

However, this LLR calculation method may cause a loss of information, and based on $L_0$, $L_1$, original information, that is, corresponding $y_0$, $y_1$ cannot be restored.

Exemplarily, an architecture in which convolutional decoding is performed by using values $L_0$, $L_1$ of the LLR described above as an input of a Viterbi decoder is shown in FIG. 3. That is, in a decoding process of a communication system, use of an LLR may help to extract original information (i.e., information sent at time of transmission) from a received signal. When the LLR is obtained in a conventional manner, it may involve more complicated arithmetic processing. In the embodiment of the present disclosure, a method in which max-log approximation is adopted is provided, and an arithmetic processing operation of the LLR is greatly simplified on a premise of maintaining certain decoding performance and even keeping the decoding performance unchanged, which may further effectively improve decoding efficiency and reduce system complexity.

As shown in FIG. 11, in a process of Viterbi decoding, each state transition on a trellis is associated with one information bit and corresponding encoded bits.

Branch metric (BM for short) may be used to measure a numerical value of possibility of transition from one state to another at a certain moment. In a communication system, BM may be used as a metric to measure a difference between a received signal and each possible transmitted signal. Therefore, it is conventional to use the branch metric (BM) to measure likelihood of a state transition in the above HRP UWB, which may generally be characterized by a combination of a series of LLR values. For example, for convolutional codes with a rate of 1/2 in a UWB, a formula for its branch metric $\gamma$ may be as follows.

$$\gamma = (1 - 2b_0) \cdot L_0 + (1 - 2b_1) \cdot L_1$$

Based on the above formula, it is understood that a basic assumption is that from the perspective of modulation, $b_0$ and $b_1$ are independent from each other. However, for the HRP UWB, $b_0$ and $b_1$ are obviously not independent of each other, because a modulated symbol pair $(x_0, x_1)$ is determined by a corresponding convolutional encoded pair $(b_0, b_1)$ jointly, instead of being mapped from $b_0$ to $x_0$ separately and from $b_1$ to $x_1$ separately and being simply combined to obtain the modulated symbol pair $(x_0, x_1)$.

In some optional embodiments of the present disclosure, a joint demapping and decoding method is also provided, as shown in FIG. 15, including: act 310, acquiring a non-Gray modulation constellation diagram; and act 320, decoding using a max-log approximation mode.

In an example of the present embodiment, for example, in a scenario such as reducing a bit error rate by using a non-Gray format to enhance correlation of symbol keys of a modulation constellation diagram, a constellation diagram obtained by modulation by the UWB equipment using BPM-BPSK joint modulation may be first acquired, that is, the non-Gray modulation constellation diagram may be the constellation diagram obtained by modulation by the UWB equipment using BPM-BPSK joint modulation; or, for the HRP-ERDEV equipment in a HPRF mode, the non-Gray modulation constellation diagram is a modulated mapping constellation diagram when convolutional codes having a constraint length of 3 is used.

In an example of the present embodiment, an acquired branch metric is decoded based on a symbol.

In an example of the present embodiment, a likelihood value of each value of the symbol is calculated through a following formula.

$$\gamma_{00} = y_0, \quad \gamma_{01} = -y_0, \quad \gamma_{10} = y_1, \quad \gamma_{11} = -y_1$$

Or, a likelihood value of each value of the symbol is calculated through a following formula.

$$\gamma_{00} = y_0 + y_1, \quad \gamma_{01} = -y_0 - y_1, \quad \gamma_{10} = -y_0 + y_1, \quad \gamma_{11} = y_0 - y_1.$$

Herein, $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $\gamma_{11}$ represents a likelihood value with a value of a symbol of 11, $y_0$ is a first component in the received symbol, $y_1$ is a second component in the received symbol.

A posteriori probability is calculated at a symbol-level rather than at a bit-level. This is because each state transition corresponds to two encoded bits mapped to one symbol, so computing a posterior probability at the symbol-level retains more information than computing a posterior probability at the bit-level.

Exemplarily, for a BPM-BPSK modulation mode, a branch metric may be set: $\gamma \propto \Pr(b_0 b_1 | y_0 y_1)$, namely as follows.

$$\gamma_{00} \overset{\text{def}}{=} \log \Pr(b_0 b_1 = 00 | y_0 y_1) = -\frac{(y_0 - 1)^2 + y_1^2}{2\sigma^2} - \log(\sigma\sqrt{2\pi})$$

$$\gamma_{01} \overset{\text{def}}{=} \log \Pr(b_0 b_1 = 01 | y_0 y_1) = -\frac{(y_0 + 1)^2 + y_1^2}{2\sigma^2} - \log(\sigma\sqrt{2\pi})$$

$$\gamma_{10} \overset{\text{def}}{=} \log \Pr(b_0 b_1 = 10 | y_0 y_1) = -\frac{y_0^2 + (y_1 - 1)^2}{2\sigma^2} - \log(\sigma\sqrt{2\pi})$$

$$\gamma_{11} \overset{\text{def}}{=} \log \Pr(b_0 b_1 = 11 | y_0 y_1) = -\frac{y_0^2 + (y_1 + 1)^2}{2\sigma^2} - \log(\sigma\sqrt{2\pi})$$

In a Viterbi decoding process, since a same constant term and proportional scaling will not affect a result of path selection, the above branch metric formula may be simplified as follows.

$$\gamma_{00} \sim -(y_0 - 1)^2 - y_1^2 \sim y_0$$

$$\gamma_{01} \sim - (y_0 + 1)^2 - y_1^2 \sim -y_0$$

$$\gamma_{10} \sim -y_0^2 - (y_1 - 1)^2 \sim y_1$$

$$\gamma_{11} \sim -y_0^2 - (y_1 + 1)^2 \sim -y_1$$

That is, a value of the above branch metric may be directly used as an ACS unit in the Viterbi decoder (such as an ACS Array shown in FIG. 5). Compared with the architecture shown in FIG. 3, since there is no LLR value for bits in an example shown in FIG. 5, only four soft information channels for symbols may be used, that is, an LLR generation module (generator) shown in FIG. 3 may be omitted.

In some optional embodiments, for HRP-ERDEV in a HPRF mode, when a constraint length of convolutional codes is 3, although a modulation solution is not BPM-BPSK, its mapping is also of non-Gray code (as shown in Table 2 below).

A specific mapping relationship may be referred to Table 2 below (wherein a power of each symbol is a unit power).

Table 2

| $(b_0, b_1)$ | $(x_0, x_1)$ |
|---|---|
| (0, 0) | (1, 1) |
| (0, 1) | (-1, -1) |
| (1, 0) | (-1, 1) |
| (1, 1) | (1, -1) |

A constellation diagram corresponding to the above Table 2 is shown in FIG. 12. At this point, a symbol-based branch metric may be calculated based on following formulas.

$$\gamma_{00} = y_0 + y_1$$

$$\gamma_{01} = -y_0 - y_1$$

$$\gamma_{10} = -y_0 + y_1$$

$$\gamma_{11} = y_0 - y_1$$

That is, based on an idea similar to that of BPM-BPSK, a solution in the present embodiment, compared with a decoding method of LLT, improves decoding performance without increasing computational complexity by using a symbol-based branch metric, thereby effectively improving decoding efficiency and reducing system complexity.

Compared with conventional solutions, regardless of comparison of performance indicators such as decoding accuracy and/or block-error-rate, performance indicators that can be achieved by technical solutions described in the embodiments of the present disclosure have been effectively improved. For example, referring to a performance comparison diagram shown in FIG. 13, it may be seen that when 20 bytes of payload data are transmitted, reliability of data transmission is improved through an Additive White Gaussian noise (AWGN) channel and using a Reed-Solomon (RS) encoding/decoding technique. In terms of performance comparison, a technical solution (curve 1) proposed by the embodiment of the present disclosure may significantly improve communication performance compared with a traditional solution (curve 2), that is, performance advantages of the present solution may be clearly shown by comparing curves 1 and 2. A curve 4 is a reference, corresponding to system performance when a modulation mode is BPSK. At this time, due to use of Gray code, performance of LLR-based decoding is similar to that of the present solution. A curve 3 is an effect of combining a common method to improve Viterbi decoding performance (list Viterbi) with the present solution. It may show that there is generally no conflict between the present solution and other optimization algorithms, and performance may be further improved by combining them. Herein, the curve 1 is BPM-BPSK, symb; the curve 2 is BPM-BPSK, LLR; the curve 3 is BPM-BPSK, symb, list-2; the curve 4 is BPSK.

It should be noted that solutions described in the embodiments of the present disclosure are not limited to a Modulation and Coding Scheme (MCS for short) specified in a UWB Physical Layer (PHY), such as a BPM-BPSK mode, and may also be applied to other solutions such as a coding and modulation system using Viterbi decoding as a channel decoding solution, as long as a code rate and a modulation order thereof satisfy preset conditions, for example: when one modulated symbol is generated at one state transition (one state transition produces one modulation symbol) in an MCS solution, in a UWB PHY scenario, a branch metric may be acquired based on the embodiments provided by the above-described embodiments of the present disclosure.

When a plurality of modulated symbols are generated at one state transition (one state transition produces multiple modulation symbols) in an MCS solution, a branch metric may be set to be equal to a sum of Euclidean distances to target constellation points.

When one modulated symbol is generated at a plurality of state transitions (multiple state transitions produce one modulation symbol) in an MCS solution, constellation points may be grouped, each group corresponds to one state transition, and a sum of Euclidean distances of each group is calculated; or, a plurality of stages may be processed at one time when forward-passing a Trellis (similar to a Radix-4 Viterbi decoder).

In summary, the technical solutions in the embodiments of the present disclosure have wide applicability and flexibility, and are not limited to a specific Modulation and Coding Scheme (MCS) in a UWB PHY, but may also be applied to different types of coding and modulation systems, such as systems that Viterbi decoding is used as a channel decoding solution, as long as code rates and modulation orders of these systems satisfy preset conditions. In some optional embodiments, a flexible way of calculating branch metrics according to different MCSs may also be provided based on a similar idea as above. For example, when one state transition produces one modulated symbol, a branch metric may be calculated according to contents described in the above embodiments. When one state transition produces a plurality of modulated symbols, a branch metric is set as a sum of Euclidean distances of these modulated symbols to their respective target constellation points. While when a plurality of state transitions produce one modulated symbol, two processing methods may be adopted: one is to group constellation points, each group corresponding to one state transition, and then calculate a sum of Euclidean distances of each group as a branch metric; another is to process a plurality of stages at one time in a forward process of Viterbi decoding, similar to a Radix-4 Viterbi decoder.

An embodiment of the present disclosure also provides an integrated circuit, which may include a radio frequency module and a signal processing module connected in sequence, and the signal processing module may introduce an LLR value into a decoding process for BPM-BPSK modulation based on the method of joint inverse mapping and decoding described in the embodiment of the present disclosure, thereby achieving introduction of correlation between symbols in the decoding process, so that a decoder may more accurately estimate a value of each coded bit, thereby improving decoding performance. In other optional embodiments, the signal processing module may also calculate a posteriori probability at a symbol-level instead of calculating a posteriori probability at a bit-level based on the method of joint inverse mapping and decoding described in the embodiment of the present disclosure. This is because each state transition corresponds to two coded bits mapped to one symbol, so computing a posterior probability at the symbol-level retains more information than computing a posterior probability at the bit-level. In other optional embodiments, based on the method of joint inverse mapping and decoding described in the embodiment of the present disclosure, for a HRP-ERDEV in a HPRF mode, when a constraint length of convolutional codes is 3, the signal processing module may use a symbol-based branch metric to improve decoding performance without increasing computational complexity, thereby effectively improving decoding efficiency and reducing system complexity. Herein, a radio frequency received signal is an echo signal formed by a radio frequency transmitted signal being emitted and/or scattered by a target, or a radio frequency transmitted signal emitted by another device. Optionally, the integrated circuit may further include a data processing module for processing a digital signal to achieve target detection and/or wireless communication, for example, the integrated circuit may be a UWB chip (chip or die).

Those of ordinary skills in the art may understand that all or some of steps in the methods disclosed above, systems, functional modules or units in apparatuses may be implemented as software, firmware, hardware, and an appropriate combination thereof. In a hardware implementation, division of the function modules/units mentioned in the above description is not always corresponding to division of physical components. For example, a physical component may have multiple functions, or a function or a step may be executed by several physical components in cooperation. Some components or all components may be implemented as software executed by a processor such as a digital signal processor or a microprocessor, or implemented as hardware, or implemented as an integrated circuit such as a specific integrated circuit. Such software may be distributed on a computer-readable medium, and the computer-readable medium may include a computer storage medium (or a non-transitory medium) and a communication medium (or a transitory medium). As known to those of ordinary skills in the art, the "term computer storage medium" includes volatile or nonvolatile, and removable or irremovable media implemented in any method or technology for storing information (for example, a computer-readable instruction, a data structure, a program module, or other data). The computer storage medium includes, is but not limited to, a Random Access Memory (RAM), a Read-Only Memory (ROM), an Electrically Erasable Programmable ROM (EEPROM), a flash memory or other memory technologies, a Compact Disc Read-Only Memory (CD-ROM), a Digital Video Disk (DVD) or other optical discs, a cassette, a magnetic tape, a disk memory or other magnetic storage apparatuses, or any other medium configurable to store expected information and accessible by a computer. In addition, it is known to those of ordinary skills in the art that the communication medium usually includes a computer-readable instruction, a data structure, a program module, or other data in a modulated data signal of, such as, a carrier or another transmission mechanism, and may include any information delivery medium.

**Claims**

1. A joint demapping and decoding method, comprising:

   acquiring a received symbol comprising a plurality of components, wherein each component of the received symbol is jointly determined by a plurality of coded bits participating in symbol mapping;
   calculating a likelihood value of each value of the symbol according to a value of the received symbol when state transition is performed in a decoding process, and obtaining a branch metric of each state transition branch based on the likelihood value.

2. The method according to claim 1, wherein
   one symbol is generated at each state transition of the decoding process, and the calculating the likelihood value of each value of the symbol according to the value of the received symbol when the state transition is performed in the decoding process comprises: calculating the likelihood value of each value of the symbol according to the value of the received symbol at each state transition of the decoding process.

3. The method according to claim 1, wherein

   one symbol is generated at each state transition of the decoding process, and a mapping relationship between coded bits and symbols is: 00 is mapped to symbol (1, 0), 01 is mapped to symbol (-1, 0), 10 is mapped to symbol (0, 1), 11 is mapped to symbol (0, -1);
   the likelihood value of each value of the symbol is calculated through a following formula:

   $$\gamma_{00} = y_0, \quad \gamma_{01} = -y_0, \quad \gamma_{10} = y_1, \quad \gamma_{11} = -y_1$$

   wherein $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $y_{11}$ represents a likelihood value with a value of a symbol of 11, $y_0$ is a first component in the received symbol, $y_1$ is a second component in the received symbol.

4. The method according to claim 3, wherein
   the method is applied to an ultra-wideband wireless communication system; a physical layer of the ultra-wideband wireless communication system works in a High Rate Pulse (HRP) mode or works in a Base Pulse Repetition Frequency (BPRF) mode as HRP-Enhanced Relative Error Detection and Verification (ERDEV) equipment; a Binary Position Modulation (BPM) - Binary Phase Shift Keying (BPSK) modulation mode is adopted for the physical layer of the ultra-wideband wireless communication system, and every two coded bits are mapped to one symbol.

5. The method according to claim 1, wherein

   one symbol is generated at each state transition of the decoding process, and a mapping relationship between coded bits and symbols is: 00 is mapped to symbol (1, 1), 01 is mapped to symbol (-1, -1), 10 is mapped to symbol (-1, 1), 11 is mapped to symbol (1, -1);
   the likelihood value of each value of the symbol is calculated through a following formula:

   $$\gamma_{00} = y_0 + y_1, \quad \gamma_{01} = -y_0 - y_1, \quad \gamma_{10} = -y_0 + y_1, \quad \gamma_{11} = y_0 - y_1$$

   wherein $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $y_{11}$ represents a likelihood value with a value of a symbol of 11, $y_0$ is a first component in the received symbol, $y_1$ is a second component in the received symbol.

**6.** The method according to claim 5, wherein
the method is applied to an ultra-wideband wireless communication system, a physical layer of the ultra-wideband wireless communication system works in a Higher Pulse Repetition Frequency (HPRF) mode as High Rate Pulse (HRP) - Enhanced Relative Error Detection and Verification (ERDEV) equipment and a constraint length of convolutional codes is equal to 3, and every two coded bits are mapped to one symbol.

**7.** The method according to any one of claims 3 to 6, wherein
the obtaining the branch metric of each state transition branch based on the likelihood value comprises: taking a calculated likelihood value of each value of the symbol as a branch metric of one corresponding state transition branch.

**8.** A joint demapping and decoding method, comprising:

acquiring a non-Gray modulation constellation diagram; and
performing decoding based on correlation between mapped symbols.

**9.** The method according to claim 8, wherein the performing decoding based on correlation between mapped symbols comprises: calculating a posterior probability for decoding based on a correlation level between mapped symbols.

**10.** A joint demapping and decoding method, comprising:

acquiring a non-Gray modulation constellation diagram; and
performing decoding using a maximum logarithmic approximation method.

**11.** The method according to claim 10, wherein the non-Gray modulation constellation diagram is a constellation diagram obtained by modulation of Ultra Wide Band (UWB) equipment using Binary Position Modulation (BPM) - Binary Phase Shift Keying (BPSK) joint modulation; or
for High Rate Pulse (HRP) - Enhanced Relative Error Detection and Verification (ERDEV) equipment in a Higher Pulse Repetition Frequency (HPRF) mode, the non-Gray modulation constellation diagram is a modulated mapping constellation diagram when convolutional codes having a constraint length of 3 are used.

**12.** The method according to claim 11, wherein an acquired branch metric is decoded based on a symbol.

**13.** The method according to claim 12, wherein

a likelihood value of each value of the symbol is calculated through a following formula:

$$\gamma_{00} = y_0, \quad \gamma_{01} = -y_0, \quad \gamma_{10} = y_1, \quad \gamma_{11} = -y_1$$

or, a likelihood value of each value of the symbol is calculated through a following formula:

$$\gamma_{00} = y_0 + y_1, \quad \gamma_{01} = -y_0 - y_1, \quad \gamma_{10} = -y_0 + y_1, \quad \gamma_{11} = y_0 - y_1$$

wherein $\gamma_{00}$ represents a likelihood value with a value of a symbol of 00, $\gamma_{01}$ represents a likelihood value with a value of a symbol of 01, $\gamma_{10}$ represents a likelihood value with a value of a symbol of 10, $y_{11}$ represents a likelihood value with a value of a symbol of 11, $y_0$ is a first component in a received symbol, $y_1$ is a second component in the received symbol.

**14.** A joint demapping and decoding apparatus, comprising a memory and a processor, the memory storing a computer program, wherein when the processor executes the computer program, the joint demapping and decoding method according to any one of claims 1 to 13 can be implemented.

**15.** A decoder, comprising a branch metric generation module and a path processing module, wherein

the branch metric generation module is configured to obtain a received symbol comprising a plurality of components from an input end, obtain a branch metric of each state transition branch according to the joint demapping and decoding method according to any one of claims 1 to 13, and output the branch metric of each state transition branch to the path processing module;

the path processing module is configured to update and record a path metric of each state based on the branch metric, determine a decoding path having a largest path metric by backtracking when an end point of a decoding path is reached, and obtain a decoded coded bit sequence based on a state sequence contained in the determined decoding path.

16. The decoder according to claim 15, wherein
the decoder is a Viterbi decoder, and the Viterbi decoder decodes convolutional codes having a code rate of 0.5.

17. An integrated circuit, comprising a radio frequency module, an analog signal processing module, and a digital signal processing module sequentially connected; wherein

the radio frequency module is configured to generate and transmit an electromagnetic wave signal, and receive an electromagnetic wave signal;
the analog signal processing module is configured to perform down-frequency processing on the received electromagnetic wave signal to obtain an intermediate frequency signal;
the digital signal processing module is configured to perform analog-to-digital conversion on the intermediate frequency signal to obtain a digital signal and process the data signal;
wherein the digital signal processing module comprises the decoder according to claim 15 or 16, or is configured to implement the joint demapping and decoding method according to any one of claims 1 to 13.

18. The integrated circuit according to claim 17, wherein the integrated circuit is a chip applied to an ultra-wideband system.

19. An electromagnetic wave device, comprising:

a carrier;
the integrated circuit according to claim 17 or 18, which is disposed on the carrier; and
an antenna disposed on the carrier, and integrated with the integrated circuit as an integral device or respectively disposed;
wherein the integrated circuit is connected with the antenna for transmitting an electromagnetic wave signal and/or receiving an electromagnetic wave signal.

20. A terminal equipment, comprising:

an equipment body; and
the electromagnetic wave device according to claim 19, which is disposed on the equipment body,
wherein the electromagnetic wave device is configured to perform target detection and/or communication to provide reference information for operation of the equipment body.

21. A non-transitory computer readable storage medium having stored thereon a computer program, wherein when the computer program is executed by a processor, the joint demapping and decoding method according to any one of claims 1 to 13 is implemented.

FIG. 1A

FIG. 1B

| PHY mode | Coded bit | Symbol | Constellation diagram |
|---|---|---|---|
| HRP mode or BPRF mode of HRP-ERDEV | 0 0<br>0 1<br>1 0<br>1 1 | (1, 0)<br>(-1, 0)<br>(0, 1)<br>(0, -1) | |
| HPRF mode of HRP-ERDEV CL=3 | 0 0<br>0 1<br>1 0<br>1 1 | (1, 1)<br>(-1, -1)<br>(-1, 1)<br>(1, -1) | |
| HPRF mode of HRP-ERDEV CL=7 | 0 0<br>0 1<br>1 0<br>1 1 | (1, 1)<br>(1, -1)<br>(-1, 1)<br>(-1, -1) | |

FIG. 2

(y0,y1) → | LLR generation module 31 | → LLR → | BM generation module 33 | → | ACS array 35 | → | Path record memory 39 | → | Path traceback module 41 | → | Decoded data memory 43 |

| State metric memory 37 |

Viterbi decoder

## FIG. 3

110

Acquire a received symbol including a plurality of components, wherein each component of the received symbol is jointly determined by a plurality of coded bits participating in symbol mapping

120

Calculate a likelihood value of each value of the symbol according to a value of the received symbol when state transition is performed in a decoding process, and obtain a branch metric of each state transition branch based on the likelihood value

## FIG. 4

(y0,y1) → | BM generation module 33 | → | ACS array 35 | → | Path record memory 39 | → | Path traceback module 41 | → | Decoded data memory 43 |

| State metric memory 37 |

Viterbi decoder

## FIG. 5

FIG. 6

FIG. 7A

FIG. 7B

FIG. 8

FIG. 9

FIG. 10a

FIG. 10b

FIG. 11

FIG. 12

FIG. 13

FIG. 14

FIG. 15

## INTERNATIONAL SEARCH REPORT

| | |
|---|---|
| International application No. | |
| **PCT/CN2025/095159** | |

### A. CLASSIFICATION OF SUBJECT MATTER

H04L1/00(2006.01)i

According to International Patent Classification (IPC) or to both national classification and IPC

### B. FIELDS SEARCHED

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; IEEE Xplore: 解映射, 逆映射, 解调, 译码, 解码, 联合, 非格雷, 状态转移, 分支度量, 符号, 似然, 超宽带, 后验概率, 网格图, demapping, demodulation, decod+, joint, non-Gray, posterior probability, branch metric, state transition, likelihood, UWB, BPM-BPSK, trellis

### C. DOCUMENTS CONSIDERED TO BE RELEVANT

| Category* | Citation of document, with indication, where appropriate, of the relevant passages | Relevant to claim No. |
|---|---|---|
| X | CN 117997473 A (BEIJING UNIVERSITY OF POSTS AND TELECOMMUNICATIONS) 07 May 2024 (2024-05-07) <br> description, paragraphs [0043]-[0144] | 8-12, 14, 21 |
| A | CN 117336128 A (QINGDAO CHRYSTAR ELECTRONIC TECHNOLOGY CO., LTD.) 02 January 2024 (2024-01-02) <br> entire document | 1-21 |
| A | CN 112688894 A (DATANG SEMICONDUCTOR TECHNOLOGY CO., LTD.) 20 April 2021 (2021-04-20) <br> entire document | 1-21 |
| A | IEEE. "IEEE Standard for Low-Rate Wireless Networks Amendment1: Enhanced Ultra Wideband (UWB) Physical Layers (PHYs) and Associated Ranging Techniques" <br> *IEEE Std 802.15.4z-2020.* 25 August 2020 (2020-08-25), <br> entire document | 1-21 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **01 August 2025** | **07 August 2025** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2025/095159**

| Patent document cited in search report | | | Publication date (day/month/year) | Patent family member(s) | | | Publication date (day/month/year) |
|---|---|---|---|---|---|---|---|
| CN | 117997473 | A | 07 May 2024 | None | | | |
| CN | 117336128 | A | 02 January 2024 | CN | 117336128 | B | 12 July 2024 |
| CN | 112688894 | A | 20 April 2021 | CN | 112688894 | B | 13 May 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410622969